# EUROPEAN PATENT SPECIFICATION

(11) **EP 4 191 667 B1**
(45) Date of publication and mention of the grant of the patent: **23.04.2025**
(21) Application number: 22211129.6
(22) Date of filing: 02.12.2022
(51) Int. Cl.: H01L 25/075, H01L 33/08, H01L 33/46, H01L 33/56, H01L 33/60

(54) **DISPLAY DEVICE**
ANZEIGEVORRICHTUNG
DISPOSITIF D'AFFICHAGE

(30) Priority: 03.12.2021 KR 20210171554; 15.12.2021 KR 20210179325; 04.10.2022 KR 20220126612
(43) Date of publication of application: 07.06.2023
(73) Proprietor: LG ELECTRONICS INC., Yeongdeungpo-gu Seoul 07336 (KR)
(72) Inventor: LEE, Sangyeol, 06772 Seoul (KR); PARK, Sangtae, 06772 Seoul (KR); JEONG, Chansung, 06772 Seoul (KR); OH, Jeongtak, 06772 Seoul (KR); JEONG, Youngkyu, 06772 Seoul (KR); PARK, Sunwoo, 06772 Seoul (KR)
(74) Representative: Frenkel, Matthias Alexander

(56) References cited:
- EP-A1- 3 093 834
- CN-A- 104 559 456
- US-A1- 2014 191 272
- US-A1- 2017 062 680
- US-A1- 2019 165 037
- US-A1- 2019 305 177
- US-A1- 2020 185 453
- US-A1- 2021 184 083

## Description

### BACKGROUND OF THE INVENTION

### Field of the Invention

The present invention is applicable to the display device relevant technical field, and, for example, relates to a display device using a layered Light Emitting Diode (LED).

### Discussion of the Related Art

Recently, in the field of display technology, display devices having excellent features such as thinness, flexibility and the like have been developed. Currently, major displays that have been commercialized are represented by Liquid Crystal Display (LCD) and Organic Light Emitting Diodes (OLED).

Meanwhile, a Light Emitting Diode (LED) is a semiconductor light emitting element well known for converting current into light, and has been used as a light source for display images of an electronic device along with GaP:N series green LEDs since 1962 when red LEDs using GaAsP compound semiconductors were commercialized.

Recently, such a Light Emitting Diode (LED) is gradually miniaturized and fabricated as a micrometer-sized LED and used as a pixel of a display device.

Such LED technology shows characteristics of low power, high luminance, and high reliability compared to other display devices/panels, and can be applied to flexible devices. Therefore, it has been actively studied in research institutes and companies in recent years.

When such an LED is used as a pixel, light traveling to a lateral side of the LED may be trapped inside a display device or a display module. This may act as a factor that degrades performance in terms of light extraction efficiency.

In addition, the light traveling to the lateral side of the LED may generate a bright line at the boundary between display modules through internal total reflection, which may act as a defect from the display perspective.

Meanwhile, in order to overcome this, the contrast may decrease when the content of the scattering agent in a scattering layer is increased. That is, the increase in the scattering agent has a trade-off relationship in which the blackness decreases in the display device. In addition, this may cause performance degradation due to an increase in a diffusive reflection property at the top of the LED.

US 2019/165037 A discloses a display device with a plurality of light-emitting elements each forming a pixel, wherein the lateral sides of a light-emitting element are covered by an insulating layer and the remaining space between the light-emitting elements is filled with a reflective or absorptive barrier layer thereby preventing light interference between adjacent pixels. From CN 104559456 A, a white solder resist layer for a printed circuit board assembled with light-emitting diodes is known. US 2019/305177 A and US 2017/062680 A disclose embodiments of light-emitting devices which include reflective layers between the individual light-emitting elements. US 2021/184083 A discloses sidewall reflectors disposed on the sidewalls of an LED which comprise porous high refractive index light scattering particles dispersed in a transparent binder. US 2014/191272 A discloses an optoelectronic component with a medium with pigments disposed between a plurality of semiconductor chips and a light diffusion layer located on a top side of the light emitting elements, the light diffusing layer containing e.g. Al₂O₃ particles. US 2020/185453 A discloses another display device.

Therefore, there is a need for a method for solving this problem.

### SUMMARY OF THE INVENTION

Accordingly, embodiments of the present invention are directed to a display device using a layered light emitting diode that substantially obviates one or more problems due to limitations and disadvantages of the related art.

One technical objective of the present invention is to provide a display device using a light emitting element, which may increase light efficiency by allowing light traveling to a lateral side of the light emitting element to travel to a front side.

Another technical objective of the present invention is to provide a display device, which may uniformize viewing angles due to different light distribution properties among red, green, and blue.

When a display device has a structure of modules connected to each other, further technical objective of the present invention is to provide a layered light emitting element and display device using the same, which may improve the effect of bright line occurrence between the modules.

Additional advantages, objects, and features of the present invention will be set forth in the detailed description as well as the accompanying drawings.

To achieve these objects, a display device with the features of claim 1 is provided. The display device includes, inter alia, a wiring substrate; a light emitting element disposed on the wiring substrate to form an individual pixel and having a semiconductor structure including a multitude of semiconductor layers stacked to emit lights of first to third colors, respectively; and a reflective layer filling a space between the light emitting elements, the reflective layer comprising: a transparent resin layer; and particles dispersed in the transparent resin layer. Further, optional features are defined in the dependent claims.

Accordingly, the present invention provides the following effects and/or advantages.

First, according to one embodiment of the present invention, it is possible to increase light efficiency by allowing light traveling to a lateral side of a light emitting element to travel to a front side.

In addition, it is possible to uniformize the viewing angles due to different light distribution properties among red, green, and blue.

In addition, when display devices have a module structure in a manner of being connected to each other, it is possible to improve the phenomenon of bright line occurrence between modules.

In addition, there is an effect of substantially extending the size of a light emitting element.

### BRIEF DESCRIPTION OF THE DRAWINGS

The present invention will become more fully understood from the detailed description given herein below and the accompanying drawings, which are given by illustration only, and thus are not limitative of the present invention, and wherein:
FIG. 1 is a cross-sectional diagram showing pixel regions of a display device using light emitting elements according to an example not belonging to the present invention;
FIG. 2A is a cross-sectional diagram showing a unit pixel region of a display device using light emitting elements according to an example not belonging to the present invention;
FIG. 2B is an enlarged diagram showing a display device using light emitting elements according to one embodiment of the present disclosure;
FIG. 3 is a cross-sectional diagram showing a light emitting element of a display device using light emitting elements according to an example not belonging to the present invention;
FIG. 4 is a diagram showing a modified example of the light emitting element of FIG. 3 not belonging to the present invention;
FIG. 5 is a cross-sectional diagram showing a light emitting element of a display device using light emitting elements according to one embodiment of the present invention;
FIG. 6 is a diagram showing a modified example of the light emitting element of FIG. 5;
FIG. 7 is a cross-sectional diagram showing a light emitting element of a display device using light emitting elements according to another embodiment of the present invention;
FIGs. 8 to 11 are schematic cross-sectional diagrams showing a process for fabricating a light emitting element of a display device using light emitting elements according to an example not belonging to the present invention;
FIGs. 12 to 15 are schematic cross-sectional diagrams showing a process for fabricating a light emitting element of a display device using light emitting elements according to another embodiment of the present invention; and
FIG. 16 is a diagram of pictures showing light emitting states by a light emitting element of a display device using light emitting elements according to another embodiment of the present invention.

### DETAILED DESCRIPTION OF THE INVENTION

Reference will now be made in detail to embodiments of the present invention, examples of which are illustrated in the accompanying drawings. Wherever possible, the same reference numbers will be used throughout the drawings to refer to the same or like parts, and redundant description thereof will be omitted. As used herein, the suffixes "module" and "unit" are added or used interchangeably to facilitate preparation of this specification and are not intended to suggest distinct meanings or functions. In describing embodiments disclosed in this specification, relevant well-known technologies may not be described in detail in order not to obscure the subject matter of the embodiments disclosed in this specification.

Furthermore, although the drawings are separately described for simplicity, embodiments implemented by combining at least two or more drawings are also within the scope of the present disclosure.

In addition, when an element such as a layer, region or module is described as being "on" another element, it is to be understood that the element may be directly on the other element or there may be an intermediate element between them.

The display device described herein is a concept including all display devices that display information with a unit pixel or a set of unit pixels. Therefore, the display device may be applied not only to finished products but also to parts. For example, a panel corresponding to a part of a digital TV also independently corresponds to the display device in the present specification. The finished products include a mobile phone, a smartphone, a laptop, a digital broadcasting terminal, a personal digital assistant (PDA), a portable multimedia player (PMP), a navigation system, a slate PC, a tablet, an Ultrabook, a digital TV, a desktop computer, and the like.

In addition, the semiconductor light emitting element mentioned in this specification is a concept including an LED, a micro LED, and the like, and may be used interchangeably therewith.

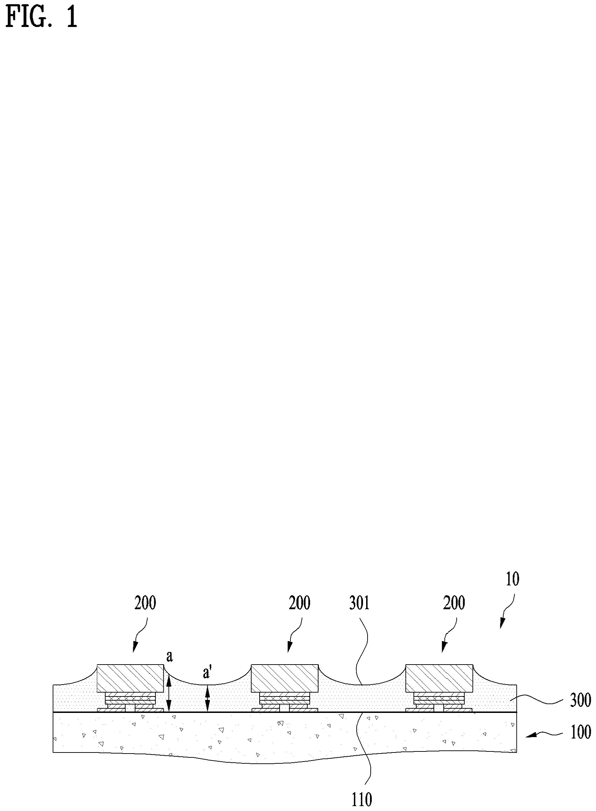

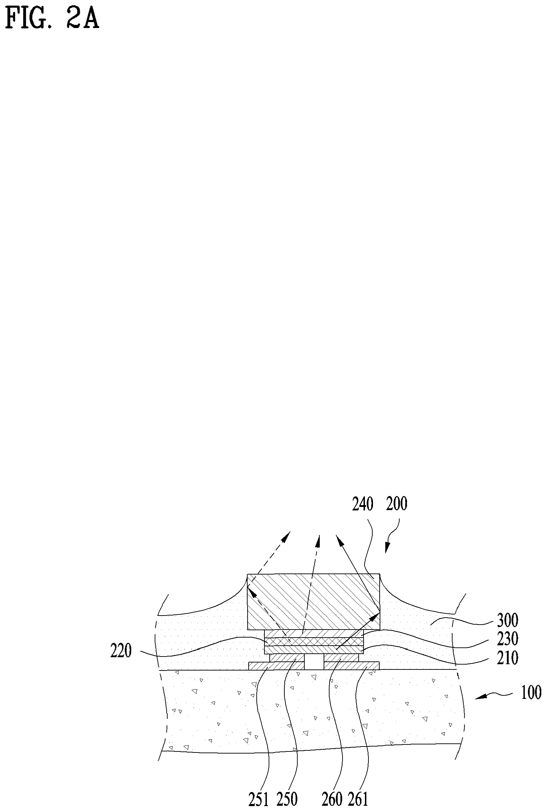

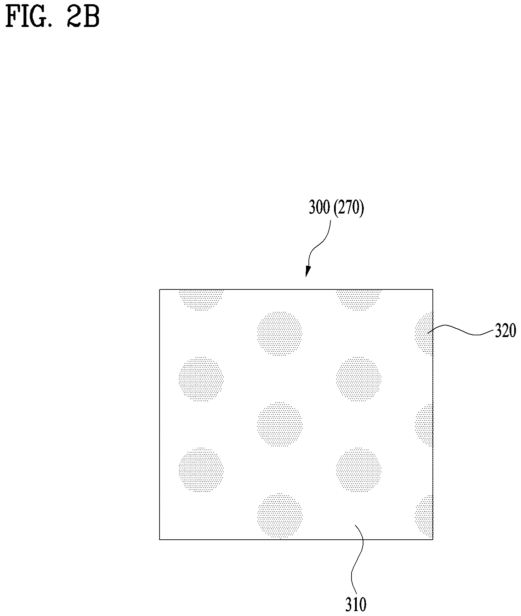

FIG. 1 is a cross-sectional diagram showing pixel regions of a display device using light emitting elements. FIG. 2A is a cross-sectional diagram showing a unit pixel region of a display device using light emitting elements. FIG. 2B is an enlarged diagram showing a display device using light emitting elements according to one embodiment of the present disclosure.

Referring to FIG. 1, in a display device 10, light emitting elements 200 that configure a multitude of pixels may be located in a manner of being arranged on a wiring substrate 100 equipped with a wiring electrode 110. In this case, a reflective layer 300 may be located among a multitude of the light emitting elements 200.

For example, the reflective layer 300 may fill a space between the light emitting elements 200. In this case, the reflective layer 300 may include reflective particles 320 (see FIG. 2B) dispersed in a transparent resin layer 310 (see FIG. 2B). This will be described in detail later.

In FIG. 1, the wiring electrode 110 is schematically illustrated. A multitude of the wiring electrodes 110 may be located on a wiring substrate 100 in a manner of being partitioned. Here, the wiring electrode 110 may include a data electrode (i.e., a pixel electrode) and a scan electrode (i.e., a common electrode).

Although not shown in the drawing, the wiring electrode 110 arranged on the wiring substrate 100 may be connected to a TFT layer provided with a Thin Film Transistor (TFT). The data electrode (i.e., the pixel electrode) may be connected to such a TFT layer. A detailed description thereof will be omitted.

In the exemplary embodiment, as illustrated, the reflective layer 300 may have a hang structure 301 between the neighboring light emitting elements 200. That is, a curved structure 301 formed concavely between the neighboring light emitting elements 200 and continuously connected may be formed on a top surface of the reflective layer 300.

In other words, a maximum height a of the light emitting element 200 may be different from a minimum height a' of the reflective layer 300. For example, the minimum height a' of the reflective layer 300 may be lower than the maximum height a of the light emitting element 200. In other words, the height a' of the hang structure 301 may be higher than half of the height a of the light emitting element 200.

The hang structure 301 may be associated with a fabricating process of the reflective layer 300. For example, when the reflective layer 300 is formed using a jetting process in which material is applied using a nozzle and then cured, the hang structure 301 may be formed.

The light emitting element 200 may be disposed on the wiring substrate 100 in a manner of forming an individual pixel. For example, a single light emitting element 200 may be configured to form a single pixel. Since the reflective layer 300 is formed to surround at least the side of the single light emitting element 200 forming the individual pixel, light emitted from the light emitting element 200 may be emitted upward without being mixed with light emitted from another light emitting element 200 forming a neighboring pixel.

That is, since light is emitted in all directions from the light emitting element 200, the light emitted in a lateral direction from the individual light emitting element 200 may be reflected by the reflective layer 300 and then emitted upward from the display device 10.

Therefore, since the light emitted from the light emitting element 200 and traveling in a lateral direction is blocked by the reflective layer 300, it is possible to fundamentally prevent the occurrence of bright lines between the pixels in the display device 10.

Referring to FIG. 2A, for example, the light emitting element 200 forming the individual pixel may include a semiconductor structure including a multitude of semiconductor layers 210, 220, and 230 stacked to emit light of a first color, a second color, and a third color.

As a specific example, the light emitting element 200 may include a layered semiconductor light emitting element capable of emitting red, green, and blue light.

For example, such a layered light emitting device 200 may include a semiconductor structure including a first semiconductor layer 210 emitting red light, a second semiconductor layer 220 emitting blue light, and a third semiconductor layer 230 emitting green light.

Here, each of the first semiconductor layer 210, the second semiconductor layer 220, and the third semiconductor layer 230 may include semiconductor layers capable of emitting light of individual colors. For example, each of the first semiconductor layer 210, the second semiconductor layer 220, and the third semiconductor layer 230 may include an active layer capable of emitting light of each individual color. As another example, each of the first semiconductor layer 210, the second semiconductor layer 220, and the third semiconductor layer 230 may include an n-type semiconductor layer and a p-type semiconductor layer together with an active layer capable of emitting light of an individual color. This individual structure is omitted in FIG. 2A.

In addition, the light emitting element 200 may include a first electrode 250 and a second electrode 260 electrically connected to one side and the other side of the semiconductor structure, respectively. In FIG. 2A, the semiconductor structure and the electrical connection structure of the first electrode 250 and the second electrode 260 are schematically illustrated.

A support layer 240 may be located on the semiconductor structure. Here, the support layer 240 may include a growth substrate in which a semiconductor structure is grown or a transfer substrate in which the semiconductor structure is transferred and bonded. The support layer 240 may be transparent with respect to light emitted from the semiconductor structure. For example, the support layer 240 may include a sapphire substrate.

Meanwhile, extension pads 251 and 261 may be provided to the first electrode 250 and the second electrode 260 electrically connected to one side and the other side of the semiconductor structure, respectively. The sizes of the extension pads 251 and 261 may increase to be larger than the outer surface of the semiconductor structure.

The description of the light emitting element 200 as other light sources will be described in detail below.

Here, the reflective layer 300 may be located to surround lateral sides of the semiconductor structure including the first semiconductor layer 210, the second semiconductor layer 220, and the third semiconductor layer 230 of the light emitting element 200 at least.

In addition, the reflective layer 300 may be located to cover the first electrode 250 and the second electrode 260. In addition, for example, the reflective layer 300 may be located to cover the extension pads 251 and 261.

The reflective layer 300 may be located to further surround a lateral side of the support layer 240 of the light emitting element 200. In an example not belonging to the present invention, the reflective layer 300 may be located to surround all sides except the top side of the support layer 240 of the light emitting element.

Referring to FIG. 2B, the reflective layer 300 includes reflective particles 320 dispersed in the transparent resin layer 310.

In an exemplary embodiment, the refractive index of the reflective particles 320 may be different from the refractive index of the transparent resin layer 310.

The reflective particles 320 may include at least one of silicon, titanium, zirconium, or an oxide thereof, that is, silicon oxide (SiOx), titanium oxide (Ti-Ox), and zirconium oxide (ZrOx).

Meanwhile, the transparent resin layer 310 may be formed of a resin material. For example, the transparent resin layer 310 may include at least one material of silicon, epoxy, and urethane.

The thickness of the reflective layer 300 may be set to have a reflectivity of 90% or more by the transparent resin layer 310 and the reflective particles 320.

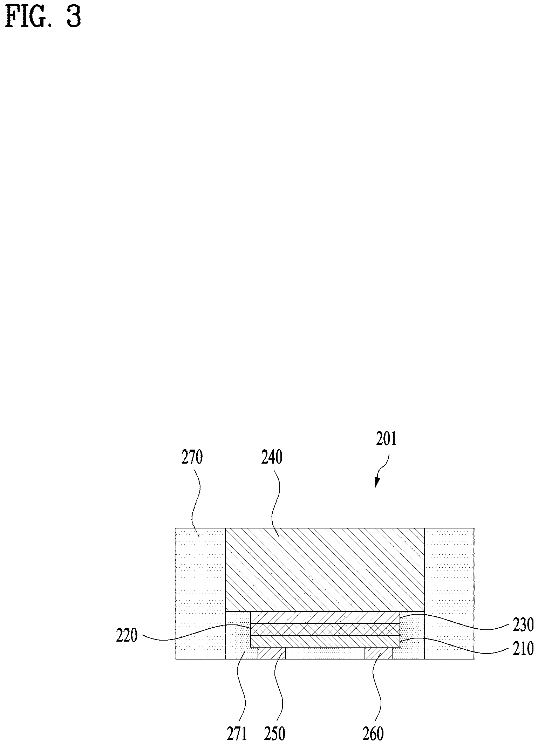

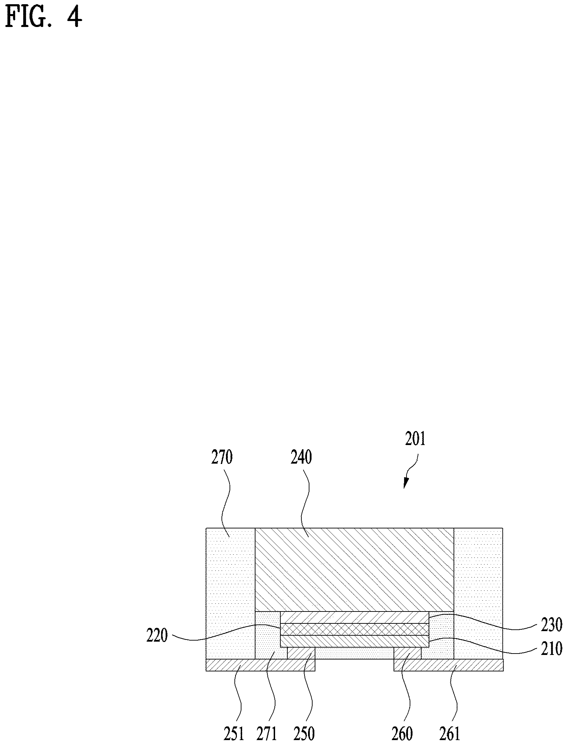

FIG. 3 is a cross-sectional diagram showing a light emitting element of a display device using light emitting elements. FIG. 4 is a diagram showing a modified example of the light emitting element of FIG. 3.

Referring to FIG. 3, a light emitting element 201 forming an individual pixel may include a semiconductor structure including a multitude of semiconductor layers 210, 220, and 230 stacked to emit lights of a first color, a second color, and a third color, respectively.

As a specific example, the light emitting element 201 may include a layered semiconductor light emitting element capable of emitting red, green, and blue lights.

For example, the layered light emitting element 201 may include a semiconductor structure including a first semiconductor layer 210 emitting red light, a second semiconductor layer 220 emitting blue light, and a third semiconductor layer 230 emitting green light.

Here, each of the first semiconductor layer 210, the second semiconductor layer 220, and the third semiconductor layer 230 may include a semiconductor layer capable of emitting light of an individual color. For example, each of the first semiconductor layer 210, the second semiconductor layer 220, and the third semiconductor layer 230 may include an active layer capable of emitting light of each individual color. As another example, each of the first semiconductor layer 210, the second semiconductor layer 220, and the third semiconductor layer 230 may include an n-type semiconductor layer and a p-type semiconductor layer together with an active layer capable of emitting light of each individual color.

In addition, the light emitting element 201 may include a first electrode 250 and a second electrode 260 electrically connected to one side and the other side of the semiconductor structure, respectively.

A support layer 240 may be located on the semiconductor structure. Here, the support layer 240 may include a growth substrate in which a semiconductor structure is grown or a transfer substrate in which the semiconductor structure is transferred and bonded. The size of the support layer 240 in a plane direction may be larger than that of the semiconductor structure.

Reflective layers 270 and 271 may be located on a lateral side of the semiconductor structure of the light emitting element 201.

Here, the reflective layers 270 and 271 may be located to surround the lateral side of the semiconductor structure including the first semiconductor layer 210, the second semiconductor layer 220, and the third semiconductor layer 230 at least.

In addition, the reflective layers 270 and 271 may be located to cover the first electrode 250 and the second electrode 260.

The reflective layers 270 and 271 may be located to further surround the lateral side of the support layer 240 of the light emitting element 201. For example, the reflective layer 300 may be located to surround all sides except the top side of the support layer 240 of the light emitting element.

In this case, as an exemplary embodiment, the reflective layer may include a first reflective layer 271 covering the lateral side and the bottom side of the semiconductor structure including the first semiconductor layer 210, the second semiconductor layer 220, and the third semiconductor layer 230 and the lateral sides of the first and second electrodes 250 and 260 and a second reflective layer 270 covering the lateral sides of the first reflective layer 271 and the support layer 240.

The reflective layers 270 and 271 may substantially extend the size of the light emitting element 201. The light emitting surface of the light emitting element 201 may be extended to a size including the reflective layers 270 and 271. That is, the light emitting surface having an area corresponding to the semiconductor structure may be extended to the size including the reflective layers 270 and 271.

Referring to FIG. 4, extension pads 251 and 261 respectively connected to the first electrode 250 and the second electrode 260 may be further provided.

The sizes of the extension pads 251 and 261 may be increased to be larger than the outer surface of the semiconductor structure. For example, the sizes of the extension pads 251 and 261 may extend to the outer surface of the reflective layer 270.

In this case, the top sides of the extension pads 251 and 261 may be in contact with the reflective layers 270 and 271. The extension pads 251 and 261 may further improve the reflectivity of the reflective layers 270 and 271. In addition, the extension pads 251 and 261 may form substantially external electrode pads of the light emitting element 201.

Other undescribed matters may be applied as described with reference to FIGs. 1 to 2B. For example, as described with reference to FIG. 2B, the reflective layers 270 and 271 may include reflective particles 320 dispersed in a transparent resin layer 310. That is, properties of the reflective layers 270 and 271 of the present embodiment may be substantially the same as those of the reflective layer 300 described above. In other words, the properties of the reflective layers 270 and 271 of the present embodiment may be the same as those of the reflective layer 300 described above, except for the property of having the hang structure 301. Thus, redundant descriptions will be omitted.

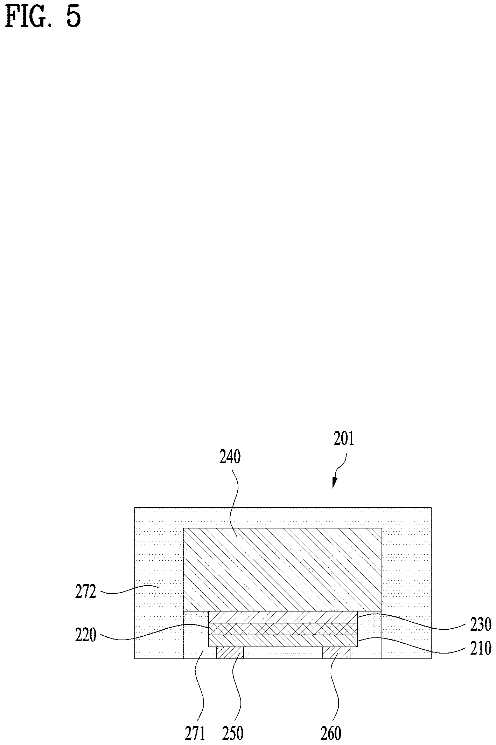

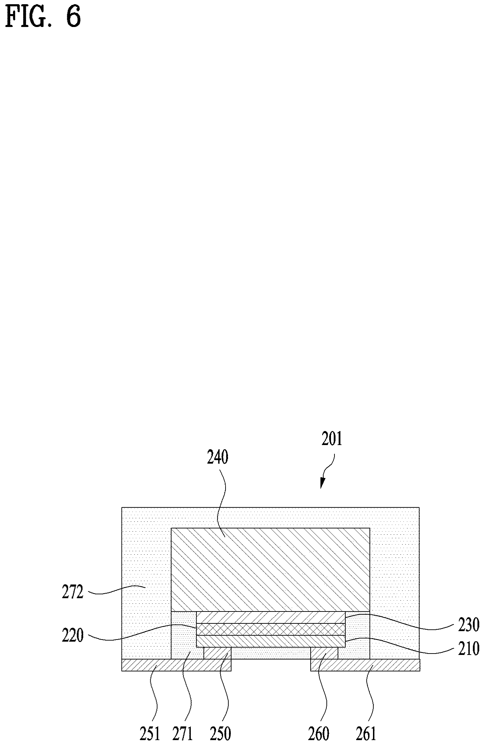

FIG. 5 is a cross-sectional diagram showing a light emitting element of a display device using light emitting elements according to an embodiment of the present invention. FIG. 6 is a diagram showing a modified example of the light emitting element of FIG. 5.

Referring to FIG. 5, a light emitting device 201 forming an individual pixel includes a semiconductor structure including a multitude of semiconductor layers 210, 220, and 230 stacked to emit lights of a first color, a second color, and a third color, respectively. Since the description of the semiconductor structure is the same as the description described with reference to FIG. 3, a redundant description will be omitted.

In addition, the light emitting element 201 includes a first electrode 250 and a second electrode 260 electrically connected to one side and the other side of the semiconductor structure, respectively.

A support layer 240 is located on the semiconductor structure. Here, the support layer 240 may include a growth substrate in which a semiconductor structure is grown or a transfer substrate in which the semiconductor structure is transferred and bonded. The size of the support layer 240 in a plane direction may be larger than that of the semiconductor structure.

Reflective layers 271 and 272 are located on a lateral side of the semiconductor structure of the light emitting element 201.

As an exemplary embodiment, the reflective layer includes a first reflective layer 271 covering lateral and bottom sides of the semiconductor structure including a first semiconductor layer 210, a second semiconductor layer 220, and a third semiconductor layer 230 and lateral sides of the first and second electrodes 250 and 260 and a second reflective layer 272 covering the first reflective layer 271 and lateral and top sides of the support layer 240.

As described above, the second reflective layer 272 is located to surround the lateral and top sides of the support layer 240 of the light emitting element 201. The second reflective layer 272 may improve uniformity of light emitted from the light emitting element 201.

The reflective layers 271 and 272 may substantially extend the size of the light emitting element 201. A light emitting surface of the light emitting element 201 may be extended to a size including the reflective layers 271 and 272. That is, the light emitting surface having an area corresponding to the semiconductor structure may be extended to the size including the reflective layers 271 and 272.

Referring to FIG. 6, extension pads 251 and 261 respectively connected to the first electrode 250 and the second electrode 260 may be further provided.

The sizes of the extension pads 251 and 261 may increase to be larger than the outer surface of the semiconductor structure. For example, the sizes of the extension pads 251 and 261 may extend to the outer surface of the reflective layer 272.

In this case, top sides of the extension pads 251 and 261 may be in contact with the reflective layers 271 and 272. The extension pads 251 and 261 may further improve the reflectivity of the reflective layers 271 and 272. In addition, the extension pads 251 and 261 may form substantially external electrode pads of the light emitting element 201.

Other undescribed matters may be applied as described with reference to FIGs. 1 to 2B, 3 and 4. For example, as described with reference to FIG. 2B, the reflective layers 271 and 272 include reflective particles 320 dispersed in a transparent resin layer 310. That is, properties of the reflective layers 271 and 272 of the present embodiment are substantially the same as those of the reflective layer 300 described above. In other words, except for the property of having the hang structure 301, the properties of the reflective layers 271 and 272 of the present embodiment may be the same as those of the reflective layer 300 described above. Thus, redundant descriptions will be omitted.

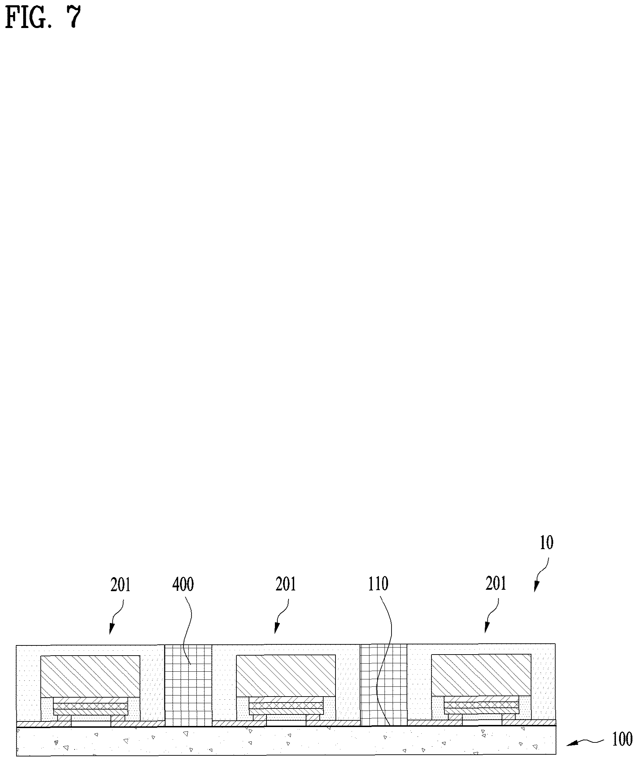

FIG. 7 is a cross-sectional diagram showing a light emitting element of a display device using light emitting elements according to another embodiment of the present invention.

Referring to FIG. 7, an embodiment of a display device 10 in which the light emitting element 201 according to the embodiment of FIG. 4 forms an individual pixel is illustrated.

That is, the light emitting element 201 according to the embodiment of FIG. 6 is installed on a wiring substrate 100 to form an individual pixel. In this case, a gap layer 400 may fill a space between the individual light emitting elements 201.

In this way, the display device 10 may be implemented with a simple structure by using the light emitting element 201 having a structure extended by the reflective layers 270, 271, and 272.

In this case, a module display device 10 including a predetermined number of light emitting elements 201 may be implemented on the wiring substrate 100 having a predetermined size. The display device 10 having a desired size may be fabricated by combining the module display devices 10.

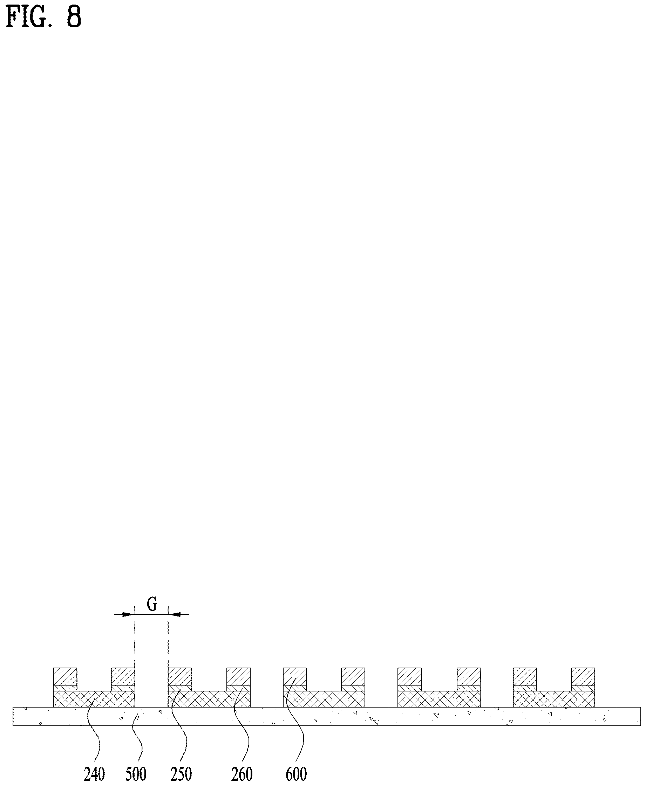

FIGs. 8 to 11 are schematic cross-sectional diagrams showing a process for fabricating a light emitting element of a display device using light emitting elements according to an example not belonging to the present invention.

Referring to FIGs. 8 to 11, a process of fabricating a light emitting element according to the embodiment shown in FIG. 4 are shown step by step.

First, referring to FIG. 8, a support layer 240 may be located on a first substrate 500 to form a predetermined gap G. In FIG. 8, a semiconductor structure located on the support layer 240 is omitted.

While a first electrode 250 and a second electrode 260 are located on the support layer 240, a photoresist 600 may be formed on the first electrode 250 and the second electrode 260.

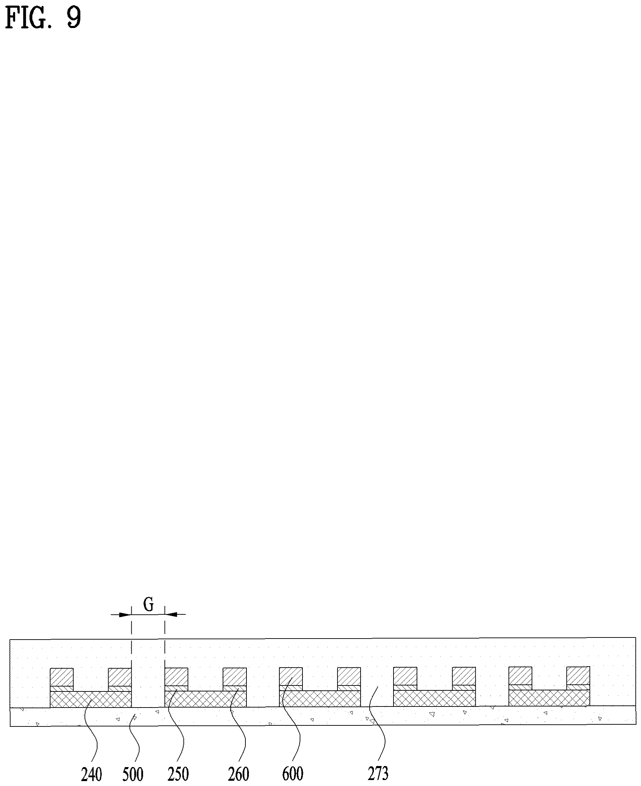

Referring to FIG. 9, a reflective layer 273 may be entirely formed in the state shown in FIG. 8. Here, the reflective layer 273 may have the same properties as the reflective layers 300, 270, 271, and 272 described above.

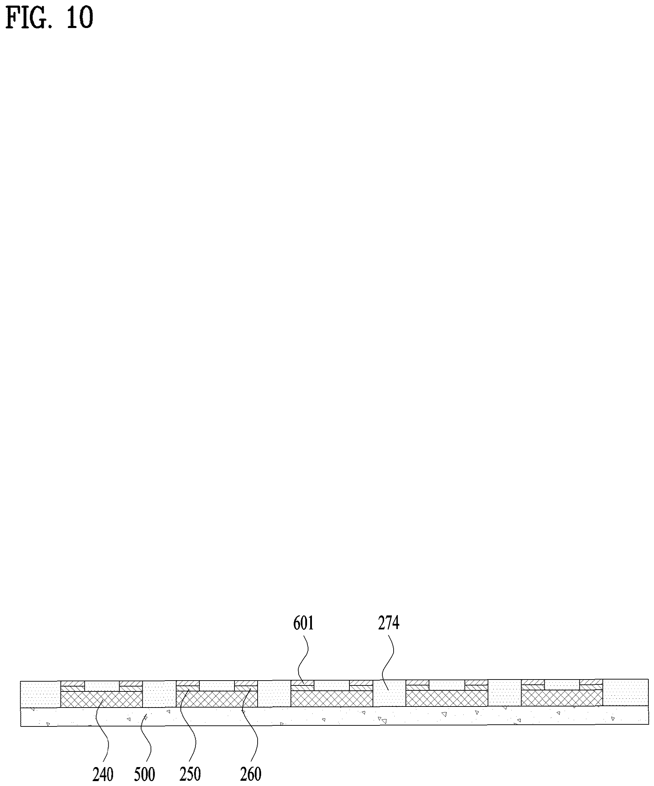

Next, referring to FIG. 10, the thickness of a top side of the structure shown FIG. 9 may be reduced. For example, as shown in FIG. 10 through a process such as wrapping the structure shown in FIG. 9, a photoresist 601 having a thinned thickness may be located on the first electrode 250 and the second electrode 260.

In this case, a reflective layer 274 having a thinned thickness may be located among the support layer 240, the first electrode 250, and the second electrode 260. That is, the reflective layer 274 may be located between the structures that will form the respective light emitting elements.

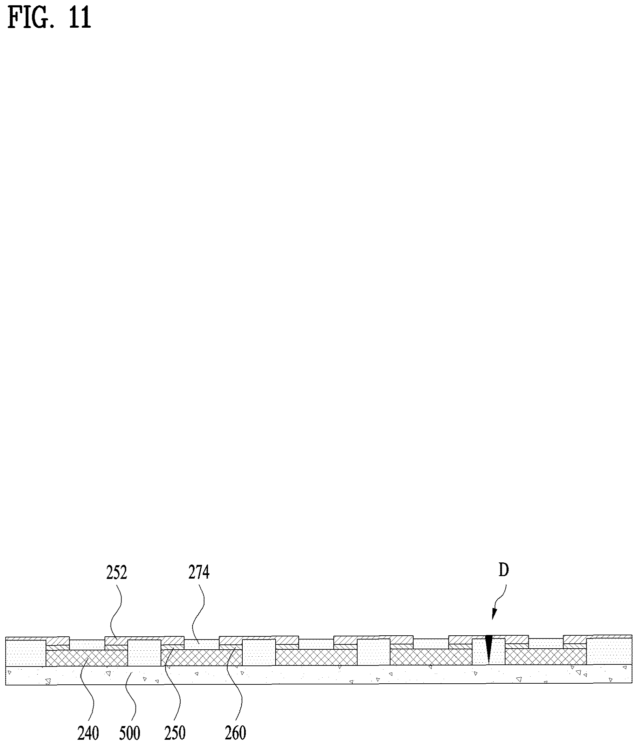

Referring to FIG. 11, a metal to form an extension pad 252 may be formed in a state in which the photoresist 601 is removed.

Thereafter, by dicing an area D dividing individual light emitting elements by such a method as laser, the light emitting element 201 having the structure shown in FIG. 4 may be fabricated.

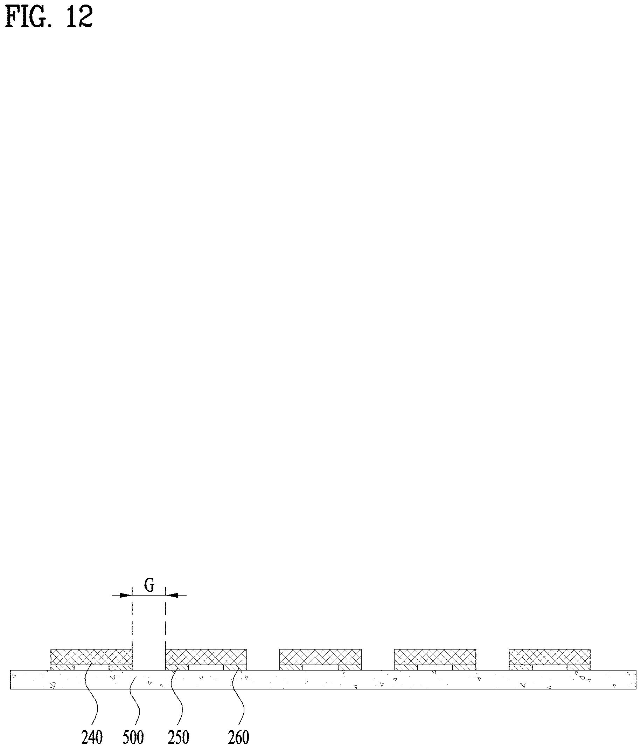

FIGs. 12 to 15 are schematic cross-sectional diagrams showing a process for fabricating a light emitting element of a display device using light emitting elements according to one embodiment of the present invention.

Referring to FIGs. 12 to 15, a process of fabricating a light emitting element shown in FIG. 6 is shown step by step.

First, referring to FIG. 12, a support layer 240 may be located on a first substrate 500 to form a predetermined interval G. In FIG. 8, a semiconductor structure located on the support layer 240 is omitted.

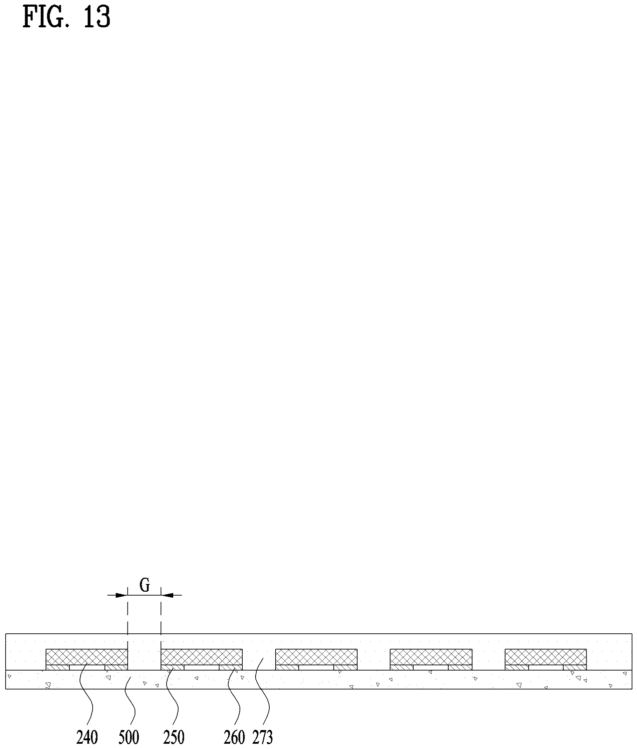

Referring to FIG. 13, a reflective layer 273 may be entirely formed in the state shown in FIG. 11. Here, the reflective layer 273 may have the same properties as the reflective layers 300, 270, 271, and 272 described above.

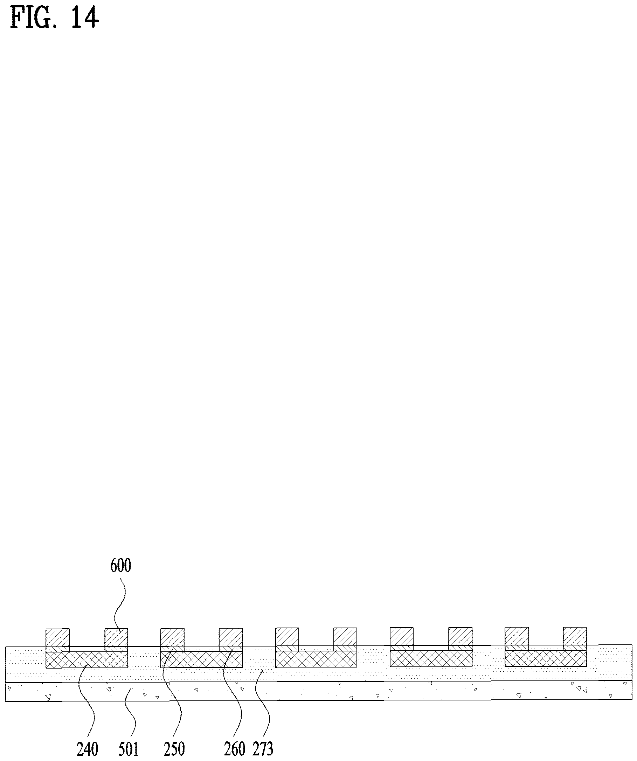

Referring to FIG. 14, the structure formed in FIG. 13 may be transferred to a second substrate 501.

In addition, while a first electrode 250 and a second electrode 260 are located on the support layer 240, a photoresist 600 may be formed on the first electrode 250 and the second electrode 260.

In this case, a reflective layer 273 may be located between the second substrate 501 and the support layer 240.

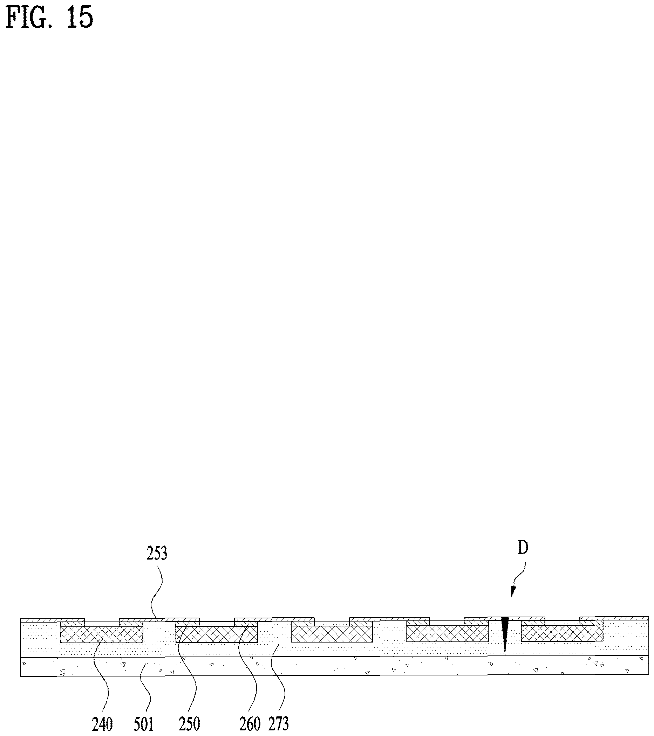

Subsequently, referring to FIG. 15, a metal to form an extension pad 252 may be formed in a state in which the photoresist 600 is removed.

Thereafter, when an area D dividing individual light emitting elements is diced by such a method as laser, a light emitting element 201 having the structure shown in FIG. 6 may be fabricated.

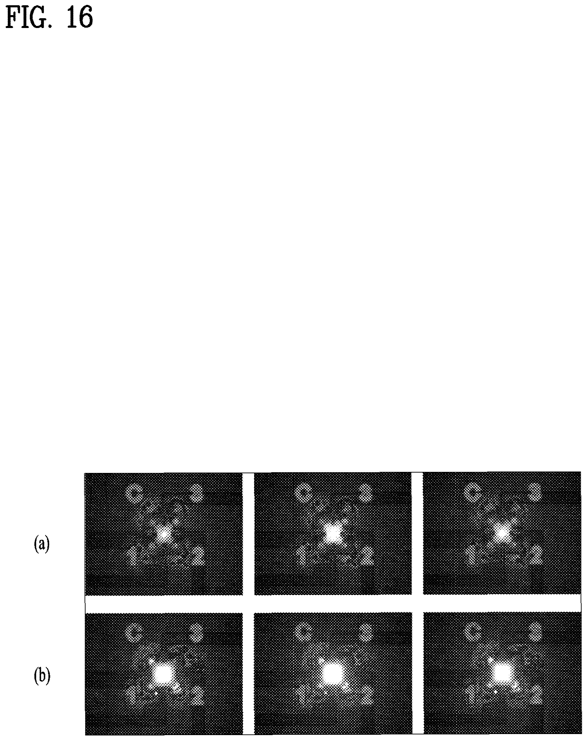

FIG. 16 is a diagram of pictures showing light emitting states by a light emitting element of a display device using light emitting elements according to another embodiment of the present disclosure.

FIG. 16 (a) illustrates a light emitting state by a light emitting element in a state in which the reflective layers 270, 271, and 272 are not provided as a comparative example.

In addition, FIG. 16 (b) illustrates a light emitting state by the light emitting element in a state in which the reflective layers 270, 271, and 272 are provided as an embodiment.

Comparing (a) and (b) of FIG. 16, it may be confirmed that the light emitting surface and the light emitting intensity are extended. That is, as described above, the size of the light emitting element 201 may be substantially extended by the reflective layers 270, 271, and 272. That is, the light emitting surface having an area corresponding to the semiconductor structure may be extended to a size including the reflective layers 270, 271, and 272.

According to an embodiment of the present invention, light traveling to a lateral side of a light emitting element is made to travel to a front side, thereby increasing light efficiency.

Moreover, it is possible to uniformize the viewing angles due to different light distribution properties among red, green, and blue.

In addition, when a display device has a structure of mutually-connected modules, it is possible to improve the effect of bright line occurrence between the modules.

It will be apparent to those skilled in the art that various modifications and variations can be made in the present invention without departing from the scope of the present invention as defined

by the appended claims.

## Claims

1. A display device (10), comprising:
a wiring substrate (100);
a plurality of light emitting elements (201), each light emitting element (201) of the plurality of light emitting elements (201) being disposed on the wiring substrate (100) to form an individual pixel and having a semiconductor structure including a multitude of semiconductor layers (210, 220, 230) stacked to emit lights of first to third colors, respectively, first and second electrodes (250, 260) electrically connected to one side and the other side of the semiconductor structure on a first face of the semiconductor structure, respectively, and a support layer (240) disposed on a second face of the semiconductor structure;
and
a reflective layer filling a space between the plurality of light emitting elements (201), the reflective layer comprising:
a transparent resin layer (310); and
reflective particles (320) dispersed in the transparent resin layer (310),
wherein the reflective layer includes a first reflection layer (271) covering the lateral side and a bottom side of the semiconductor structure of each light emitting element (201), and a second reflection layer (272) covering the lateral sides of the first reflective layer (271) and the support layer (240) of each light emitting element (201) and being located on a top side of the support layer (240) of each light emitting element (201).

2. The display device (10) of claim 1, wherein the reflective layer has a hang structure (301) between neighboring light emitting elements (201).

3. The display device (10) of claim 2, wherein a height of the hang structure (301) is greater than a half of a height of each of the neighboring light emitting elements (201).

4. The display device (10) of any one of claims 1 to 3, wherein a refractive index of the reflective particles (320) is different from a refractive index of the transparent resin layer (310).

5. The display device (10) of any one of claims 1 to 4, wherein the reflective particles (320) include at least one of silicon oxide, titanium oxide, or zirconium oxide.

6. The display device (10) of any one of claims 1 to 5, wherein thickness of the reflective layer is set to have a reflectivity of 90% or more by the transparent resin layer (310) and the reflective particles (320).

7. The display device (10) of any one of claims 1 to 6, wherein the transparent resin layer (310) includes at least one material of silicon, epoxy, or urethane.

8. The display device (10) of claim 1, wherein the first reflective layer (271) has a predetermined thickness on the lateral side of the semiconductor structure.

9. The display device (10) of claim 1, each light emitting element (201) further comprises an extension pad (251, 261) connected to each of the first electrode (250) and the second electrode (260).

10. The display device (10) of claim 9, wherein an outer side end of the extension pad (251, 261) is in contact with the reflective layer.

## Patentansprüche

1. Anzeigevorrichtung (10), umfassend:
ein Verdrahtungssubstrat (100);
eine Mehrzahl von lichtemittierenden Elementen (201), wobei jedes lichtemittierende Element (201) der Mehrzahl von lichtemittierenden Elementen (201) auf dem Verdrahtungssubstrat (100) angeordnet ist, um ein einzelnes Pixel zu bilden, und eine Halbleiterstruktur aufweist, die eine Mehrzahl von Halbleiterschichten (210, 220, 230), die gestapelt sind, um Licht einer jeweiligen ersten bis dritten Farbe zu emittieren, eine erste und eine zweite Elektrode (250, 260), die elektrisch mit einer Seite und einer anderen Seite der Halbleiterstruktur auf einer ersten Fläche der Halbleiterstruktur verbunden sind, und eine Trägerschicht (240), die auf einer zweiten Fläche der Halbleiterstruktur angeordnet ist, enthält; und
eine reflektierende Schicht, die einen Raum zwischen der Mehrzahl von lichtemittierenden Elementen (201) ausfüllt, wobei die reflektierende Schicht umfasst:
eine transparente Harzschicht (310); und
reflektierende Partikel (320), die in der transparenten Harzschicht (310) verteilt sind,
wobei die reflektierende Schicht eine erste Reflexionsschicht (271), die die laterale Seite und eine untere Seite der Halbleiterstruktur jedes lichtemittierenden Elements (201) bedeckt, und eine zweite Reflexionsschicht (272), die die lateralen Seiten der ersten Reflexionsschicht (271) und die Trägerschicht (240) jedes lichtemittierenden Elements (201) bedeckt und auf einer oberen Seite der Trägerschicht (240) jedes lichtemittierenden Elements (201) angeordnet ist, umfasst.

2. Anzeigevorrichtung (10) nach Anspruch 1, wobei die reflektierende Schicht eine Hängestruktur (301) zwischen benachbarten lichtemittierenden Elementen (201) aufweist.

3. Anzeigevorrichtung (10) nach Anspruch 2, wobei eine Höhe der Hängestruktur (301) größer ist als die Hälfte der Höhe jedes der benachbarten lichtemittierenden Elemente (201).

4. Anzeigevorrichtung (10) nach einem der Ansprüche 1 bis 3, wobei sich der Brechungsindex der reflektierenden Partikel (320) von einem Brechungsindex der transparenten Harzschicht (310) unterscheidet.

5. Anzeigevorrichtung (10) nach einem der Ansprüche 1 bis 4, wobei die reflektierenden Partikel (320) mindestens eines von Siliziumoxid, Titanoxid oder Zirkoniumoxid enthalten.

6. Anzeigevorrichtung (10) nach einem der Ansprüche 1 bis 5, wobei die Dicke der reflektierenden Schicht so eingestellt ist, dass sie durch die transparente Harzschicht (310) und die reflektierenden Partikel (320) ein Reflexionsvermögen von 90 % oder mehr aufweist.

7. Anzeigevorrichtung (10) nach einem der Ansprüche 1 bis 6, wobei die transparente Harzschicht (310) mindestens ein Material aus Silikon, Epoxid oder Urethan enthält.

8. Anzeigevorrichtung (10) nach Anspruch 1, wobei die erste Reflexionsschicht (271) eine vorbestimmte Dicke auf der lateralen Seite der Halbleiterstruktur aufweist.

9. Anzeigevorrichtung (10) nach Anspruch 1, wobei jedes lichtemittierende Element (201) ferner ein Verlängerungskissen (251, 261) umfasst, das mit jeder der ersten Elektrode (250) und der zweiten Elektrode (260) verbunden ist.

10. Anzeigevorrichtung (10) nach Anspruch 9, wobei ein äußeres Seitenende des Verlängerungskissens (251, 261) in Kontakt mit der reflektierenden Schicht ist.

## Revendications

1. Dispositif d'affichage (10), comprenant:
un substrat de câblage (100);
une pluralité d'éléments électroluminescents (201), chaque élément électroluminescent (201) de la pluralité d'éléments électroluminescents (201) étant disposé sur le substrat de câblage (100) pour former un pixel individuel et ayant une structure semi-conductrice comprenant une multitude de couches semi-conductrices (210, 220, 230) empilées pour émettre respectivement des lumières de la première à la troisième couleur, des première et deuxième électrodes (250, 260) connectées électriquement à un côté et à l'autre côté de la structure semi-conductrice sur une première face de la structure semi-conductrice, respectivement, et une couche de support (240) disposée sur une deuxième face de la structure semi-conductrice;
et
une couche réfléchissante remplissant un espace entre la pluralité d'éléments électroluminescents (201), la couche réfléchissante comprenant:
une couche de résine transparente (310); et
des particules réfléchissantes (320) dispersées dans la couche de résine transparente (310),
dans lequel la couche réfléchissante comprend une première couche réfléchissante (271) recouvrant le côté latéral et le côté inférieur de la structure semi-conductrice de chaque élément électroluminescent (201), et une deuxième couche réfléchissante (272) couvrant les côtés latéraux de la première couche réfléchissante (271) et la couche de support (240) de chaque élément électroluminescent (201) et étant située sur un côté supérieur de la couche de support (240) de chaque élément électroluminescent (201).

2. Dispositif d'affichage (10) selon la revendication 1, dans lequel la couche réfléchissante a une structure suspendue (301) entre les éléments électroluminescents voisins (201).

3. Dispositif d'affichage (10) selon la revendication 2, dans lequel la hauteur de la structure suspendue (301) est supérieure à la moitié de la hauteur de chacun des éléments électroluminescents (201).

4. Dispositif d'affichage (10) selon l'une quelconque des revendications 1 à 3, dans lequel l'indice de réfraction des particules réfléchissantes (320) est différent de l'indice de réfraction de la couche de résine transparente (310).

5. Dispositif d'affichage (10) selon l'une quelconque des revendications 1 à 4, dans lequel les particules réfléchissantes (320) comprennent au moins l'un parmi l'oxyde de silicium, l'oxyde de titane ou l'oxyde de zirconium.

6. Dispositif d'affichage (10) selon l'une quelconque des revendications 1 à 5, dans lequel l'épaisseur de la couche réfléchissante est définie de manière à ce qu'elle présente une réflectivité de 90% ou plus par la couche de résine transparente (310) et les particules réfléchissantes (320).

7. Dispositif d'affichage (10) selon l'une quelconque des revendications 1 à 6, dans lequel la couche de résine transparente (310) comprend au moins un matériau parmi le silicium, l'époxy ou l'uréthane.

8. Dispositif d'affichage (10) selon le revendication 1, dans lequel la première couche réfléchissante (271) a une épaisseur prédéterminée sur la face latérale de la structure semi-conductrice.

9. Dispositif d'affichage (10) selon le revendication 1, chaque élément électroluminescent (201) comprend en outre une pastille d'extension (251, 261) relié à la première électrode (250) et à la deuxième électrode (260).

10. Dispositif d'affichage (10) selon le revendication 9, dans lequel une extrémité latérale extérieure de la pastille d'extension (251, 261) est en contact avec la couche réfléchissante.
